# DEMANDE DE BREVET EUROPEEN

(11) **EP 0 997 931 A1**
(43) Date de publication de la demande: **03.05.2000**
(21) Numéro de dépôt: 99410142.6
(22) Date de dépôt: 22.10.1999
(51) Int. Cl.: H01L 21/761, H01L 29/06, H01L 21/225

(54) **Procédé de réalisation d'un mur d'isolation dans un substrat semiconducteur**

(30) Priorité: 23.10.1998 FR 9813544
(71) Demandeur: STMicroelectronics SA, 94250 Gentilly Cedex (FR)
(72) Inventeur: Anceau, Christine, 37390 Saint Roch (FR); Pierre, Fabien, 35510 Cesson Sévigné (FR); Bonnaud, Olivier, 35510 Cesson Sévigné (FR)
(74) Mandataire: de Beaumont, Michel

(57) **Abrégé**

L'invention concerne un procédé de formation de mur d'isolement dans un substrat semiconducteur d'un premier type de conductivité, comprenant les étapes consistant à percer dans le substrat des évidements non jointifs selon le contour du mur d'isolement désiré ; remplir les évidements d'un matériau contenant un dopant du deuxième type de conductivité ; et procéder à une étape de recuit pour que des régions du deuxième type de conductivité diffusées à partir d'évidements voisins se rejoignent. Une première série d'évidements (20) est formée à partir de la face supérieure et une deuxième série d'évidements (30) est formée à partir de la face inférieure. Les évidements ont une section sensiblement rectangulaire dont la grande dimension est perpendiculaire à l'alignement des évidements et ont une profondeur inférieure ou égale à la demi épaisseur du substrat.

## Description

La présente invention concerne la fabrication de composants semiconducteurs et plus particulièrement de composants semiconducteurs de puissance.

Les composants semiconducteurs et notamment les composants semiconducteurs de puissance ayant des structures de plus en plus complexes, on trouve maintenant souvent sur une même puce semiconductrice divers composants qui doivent être isolés latéralement les uns des autres. On considérera ici le cas où cet isolement est réalisé en prévoyant des murs d'isolement d'un type de conductivité opposé à celui du substrat.

Dans le domaine des composants de puissance, un problème particulier se pose du fait que ces murs d'isolement doivent être profonds et traverser toute une plaquette de silicium. Classiquement, ces murs d'isolement sont réalisés par des diffusions profondes en vis-à-vis formées à partir des faces supérieure et inférieure d'une plaquette de silicium.

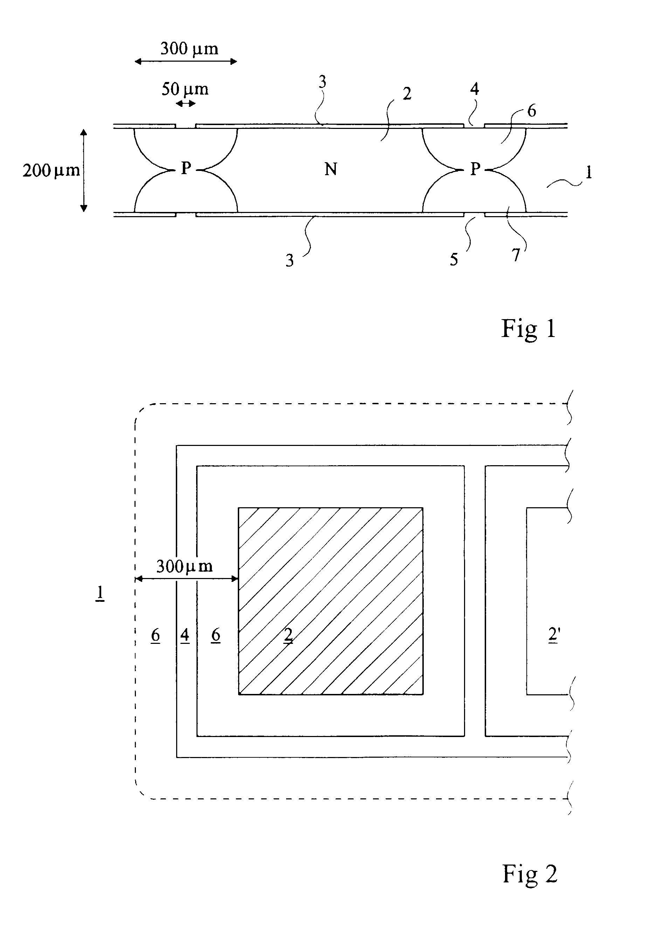

La figure 1 représente en coupe et la figure 2 en vue de dessus une portion d'une plaquette semiconductrice 1 de type N dans laquelle sont formés des murs d'isolement pour délimiter une portion 2 de la région semiconductrice. Les murs d'isolement sont généralement réalisés en prévoyant des masques 3 munis d'ouvertures 4 et 5 en regard sur les faces supérieure et inférieure de la plaquette semiconductrice selon le contour du mur d'isolement désiré. Ensuite, à partir de ces ouvertures sont formées des diffusions de type opposé à celui du substrat, ici de type P, respectivement 6 et 7, suffisamment profondes pour se rejoindre.

Le temps de réalisation de ces murs diffusés est très important et la température de traitement doit être élevée. Ainsi, on tend à utiliser des plaquettes aussi minces que possible pour réduire la durée de cette étape. Dans le cas d'une plaquette d'une épaisseur de 200 µm, il faudra prévoir des diffusions dont la profondeur est de par exemple 125 µm pour être sûr que les diffusions en regard se rejoignent convenablement. Avec un dopage au bore dans un substrat de type N, cette opération nécessite un traitement thermique de 300 heures à 1280°C.

Un autre inconvénient de la réalisation d'un mur d'isolement par diffusion à partir des surfaces supérieure et inférieure réside dans la surface occupée par le mur obtenu. En effet, lors d'une étape de diffusion, une diffusion latérale se produit sensiblement à la même vitesse que la diffusion transversale. Ainsi, si on cherche à faire une diffusion d'une profondeur de 125 µm, cette diffusion s'étendra aussi latéralement d'une longueur de 125 µm. Comme cela est indiqué en figure 1, si l'ouverture 4 a une largeur de l'ordre de 50 µm, la largeur totale du mur d'isolement sera de l'ordre de 300 µm. Pour une plaquette de 300 µm d'épaisseur, cette largeur deviendrait supérieure à 500 µm (0, 5 mm), alors que la largeur de la zone où se rejoignent les murs d'isolement dans le plan médian de la plaquette n'est que de quelques dizaines de micromètres.

Ces dimensions des murs d'isolement sont loin d'être négligeables en pratique. En effet, sachant qu'une structure de puissance verticale classique telle que celle d'un thyristor fonctionne avec une densité de courant moyenne de 2 A/mm², un composant destiné à laisser passer un courant de l'ordre de 2 A aura une surface de 1 mm² tandis que le mur d'isolement qui l'entoure aura une surface de l'ordre de 1,56 mm². Ainsi, le mur d'isolement occupe plus de surface de silicium que le composant lui-même. Un composant destiné à laisser passer un courant de 10 A aura une surface active de 5 mm² et son mur d'isolement occupera une surface de 3 mm². L'augmentation de surface de silicium liée au mur sera dans ce cas de 60 %.

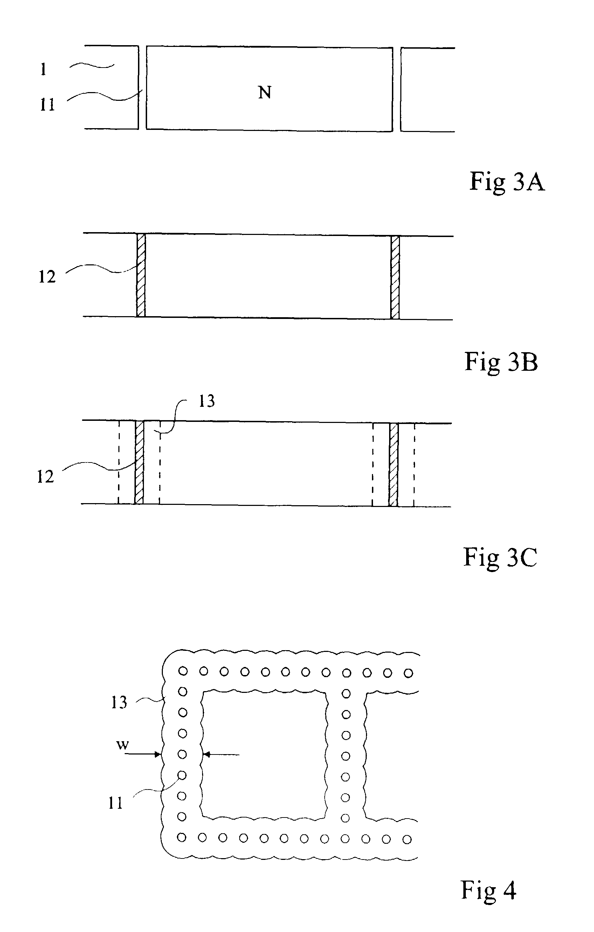

Les figures 3A à 3C sont des vues en coupe d'un substrat semiconducteur illustrant des étapes successives de formation d'un autre type de mur d'isolement connu et la figure 4 en représente une vue de dessus.

Comme le représente la figure 3A, dans une première étape, on perce dans un substrat de silicium des puits cylindriques 11. Avec des procédés connus, on peut obtenir des trous d'un diamètre de 1 à 5 µm.

Comme le montre la figure 4, les trous 11 sont alignés et espacés les uns des autres selon le contour du mur d'isolement que l'on cherche à obtenir.

Dans une deuxième étape illustrée en figure 3B, les trous 11 sont remplis d'un matériau 12 pouvant servir de source pour un dopant de type opposé à celui du substrat. Par exemple, si le substrat est de type N, ce dopant pourra être du bore et le matériau 12 pourra être du silicium polycristallin dopé au bore. Le remplissage des trous peut se faire par dépôt chimique en phase vapeur à basse pression.

Dans une troisième étape, illustrée en figure 3C, la plaquette est soumise à un traitement thermique de sorte que le dopant de type P inclus dans le matériau 12 diffuse à partir des parois des trous cylindriques 11 et cette diffusion est poursuivie jusqu'à ce que les régions diffusées 13 de deux trous adjacents se rejoignent.

Le résultat obtenu est illustré à titre d'exemple en figure 4. On notera que l'épaisseur w du mur d'isolement obtenu dépend seulement du diamètre des trous 11 et de la distance entre ces trous. En choisissant par exemple des trous d'un diamètre de 5 µm espacés de 20 µm, on pourra procéder à une étape de diffusion produisant une région diffusée d'une étendue de 12,5 µm, c'est-à-dire que la plus grande largeur du mur d'isolement sera égale à 5 + 2x12,5 = 30 µm. L'homme de l'art choisira la dimension et la distance entre trous en fonction de la durée de diffusion que son processus de fabrication peut admettre. On notera à titre d'exemple que la durée nécessaire à l'obtention d'une diffusion d'une longueur de 10 µm avec du bore est de 10 heures à 1200°C. Le traitement thermique est donc beaucoup moins contraignant que précédemment.

Ainsi, le procédé de création de mur par perçage de trous présente par rapport au procédé par diffusion l'avantage d'un moindre encombrement. Il présente par contre l'inconvénient, que, dans de nombreux cas, il faut quand même que le mur d'isolement ait une certaine épaisseur et un niveau de dopage minimal aux emplacements où se rejoignent les diffusions en provenance de deux trous parallèles. Pour résoudre ce problème, on a proposé dans l'art antérieur des systèmes comprenant plusieurs lignes de trous en parallèle. Toutefois, ces systèmes présentent l'inconvénient de fragiliser la plaquette de silicium et l'on est amené à des compromis difficiles entre le choix de la distance entre trous parallèles et le choix de la durée de recuit.

Ainsi, chacun des systèmes antérieurs susmentionnés présente des inconvénients.

La présente vise à pallier un ou plusieurs des inconvénients des systèmes antérieurs.

Plus particulièrement, la présente invention prévoit de fabriquer des murs d'isolement efficaces, n'ayant qu'une faible largeur inutile en plus de leur largeur utile, et relativement simples et rapides à fabriquer.

Pour atteindre ces objets, la présente invention prévoit un procédé de formation de mur d'isolement dans un substrat semiconducteur d'un premier type de conductivité, comprenant les étapes consistant à percer dans le substrat des évidements non jointifs selon le contour du mur d'isolement désiré ; remplir les évidements d'un matériau contenant un dopant du deuxième type de conductivité ; procéder à une étape de recuit pour que des régions du deuxième type de conductivité diffusées à partir d'évidements voisins se rejoignent ; et former une première série d'évidements à partir de la face supérieure et une deuxième série d'évidements à partir de la face inférieure, les évidements ayant une section sensiblement rectangulaire dont la grande dimension est perpendiculaire à l'alignement des évidements et une profondeur inférieure ou égale à la demi épaisseur du substrat.

Selon un mode de réalisation de la présente invention, les première et deuxième séries d'évidements, vues en projection perpendiculairement au plan du substrat, sont alternées.

Selon un mode de réalisation de la présente invention, les évidements sont formés par gravure sèche.

La présente invention prévoit aussi un mur d'isolement du deuxième type de conductivité dans un substrat du premier type de conductivité, comprenant des lignes d'évidements remplis de matériau dopé du deuxième type de conductivité et des zones diffusées du deuxième type de conductivité s'étendant autour de chaque évidement, les zones correspondant à deux évidements voisins se rejoignant. Une première série d'évidements s'étend à partir de la face supérieure et une deuxième série d'évidements s'étend à partir de la face inférieure. Les évidements ont une section rectangulaire dont la grande dimension est perpendiculaire à la ligne des évidements et ont une profondeur inférieure ou égale à la demi épaisseur du substrat.

Selon un mode de réalisation de la présente invention, les première et deuxième séries d'évidements, vues en projection perpendiculairement au plan du substrat, sont alternées.

La présente invention prévoit aussi un composant comportant un mur d'isolement du type ci-dessus.

Ces objets, caractéristiques et avantages ainsi que d'autres de la présente invention seront exposés en détail dans la description suivante de modes de réalisation particuliers faite, à titre non-limitatif, en relation avec les figures jointes parmi lesquelles :
les figures 1 et 2 illustrent, en coupe et en vue de dessus, un mur d'isolement classique obtenu par diffusion ;
les figures 3A à 3C sont des vues en coupe d'un substrat semiconducteur illustrant des étapes successives de formation d'un autre type de mur d'isolement connu ;
la figure 4 représente une vue de dessus du mur d'isolement obtenu par le procédé des figures 3A à 3C ;
les figures 5A et 5B représentent respectivement une vue de dessus schématique et une vue en coupe schématique d'une portion d'un mur d'isolement selon la présente invention ; et
la figure 6 est une vue de dessus schématique à plus grande échelle d'un mur d'isolement selon la présente invention.

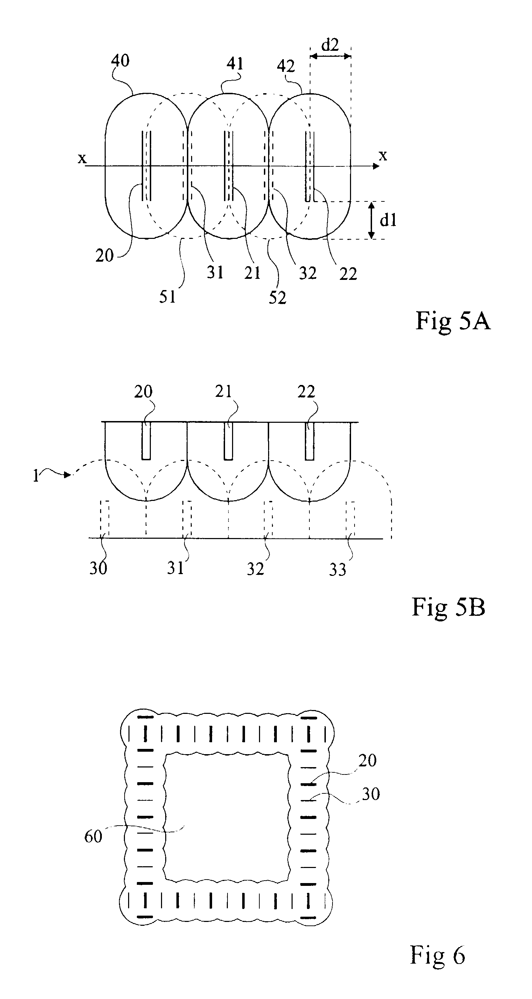

Comme le représentent les figures 5A et 5B, un mur d'isolement selon la présente invention est formé à partir d'une succession d'évidements alignés 20, 21, 22... formés du côté de la face supérieure d'une tranche semiconductrice et d'une succession d'évidements alignés 30, 31, 32, 33... formés du côté de la face inférieure de la plaquette semiconductrice. Les lignes X-X reliant les centres des évidements du côté de la face supérieure et du côté de la face inférieure sont confondues selon une projection perpendiculaire au plan de la plaquette semiconductrice. Chacun des évidements 20-22, 30-33 a une section rectangulaire dont la grande direction est perpendiculaire à la ligne X-X.

Selon une caractéristique de la présente invention, visible en figure 5B, la profondeur des évidements est inférieure ou égale à la demi épaisseur de la plaquette et les évidements supérieurs et inférieurs sont disposés de façon alternée.

Les évidements sont par exemple formés par gravure sèche séquentiellement du côté de la face supérieure puis du côté de la face inférieure du substrat.

Ensuite, comme cela a été décrit en relation avec les figures 3B et 3C, les évidements sont remplis d'une source d'un dopant de type opposé à celui du substrat, par exemple du silicium polycristallin dopé au bore et le dopant est amené à diffuser. Ainsi, les évidements 20-22 sont la source de régions diffusées respectives 40-42 tandis que les évidements 31-32 du côté de la face inférieure sont la source de régions diffusées respectives 51-52. La diffusion est poursuivie suffisamment longtemps pour que les zones diffusées s'étendant à partir de deux évidements voisins d'une même face se rejoignent. Egalement, comme on le voit dans la vue en coupe, ces diffusions sont poursuivies suffisamment longtemps pour que les régions diffusées en provenance d'évidements voisins des faces supérieure et inférieure du substrat se rejoignent.

Selon un avantage de la présente invention, il a été constaté que, quand on forme une diffusion à partir d'une zone rectangulaire, la distance de diffusion dl dans la direction du grand côté du rectangle est plus petite que la distance de diffusion d2 du côté du petit côté du rectangle (voir figure 5A) ce qui assure une bonne fermeture du mur d'isolement pour une durée de diffusion limitée.

La figure 6 représente une vue de dessus d'une zone 60 d'un substrat semiconducteur entourée d'un mur obtenu selon la présente invention. On a désigné par un trait plus épais les évidements 20 formés du côté de la surface supérieure du substrat et d'un trait plus mince les évidements 30 formés du côté de la face inférieure du substrat.

Bien entendu, la présente invention est susceptible de nombreuses variantes et modifications qui apparaîtront à l'homme de métier. En particulier, il pourra choisir d'autres matériaux de remplissage des évidements, la seule exigence étant que ces matériaux puissent servir de source de dopant de type opposé à celui du substrat et puissent être amenés à remplir les évidements par un procédé relativement simple tel qu'un dépôt chimique en phase vapeur. Des formes autres que des simples rectangles peuvent également être choisies. Divers dessins pourront être adoptés pour les coins de murs, par exemple des arrondis.

Uniquement à titre d'exemple, pour une plaquette d'une épaisseur de 210 à 220 µm, on pourra choisir pour chaque évidement 20-22, 30-33, une profondeur de 100 µm, une longueur de 20 à 40 µm et une largeur de 2 à 4 µm, la distance entre ouvertures voisines d'un même côté de la plaquette étant de 15 à 30 µm.

## Revendications

1. Procédé de formation de mur d'isolement dans un substrat semiconducteur (1) d'un premier type de conductivité, comprenant les étapes suivantes :
percer dans le substrat des évidements non jointifs selon le contour du mur d'isolement désiré ;
remplir les évidements d'un matériau contenant un dopant du deuxième type de conductivité ;
procéder à une étape de recuit pour que des régions du deuxième type de conductivité diffusées à partir d'évidements voisins se rejoignent ;
caractérisé en ce qu'une première série d'évidements (20-22) est formée à partir de la face supérieure et une deuxième série d'évidements (30-33) est formée à partir de la face inférieure, et en ce que les évidements ont une section sensiblement rectangulaire dont la grande dimension est perpendiculaire à l'alignement des évidements et ont une profondeur inférieure ou égale à la demi épaisseur du substrat.

2. Procédé selon la revendication 1, caractérisé en ce que les première et deuxième séries d'évidements, vues en projection perpendiculairement au plan du substrat, sont alternées.

3. Procédé selon la revendication 1, caractérisé en ce que les évidements sont formés par gravure sèche.

4. Mur d'isolement du deuxième type de conductivité dans un substrat du premier type de conductivité, comprenant des lignes d'évidements remplis de matériau dopé du deuxième type de conductivité et des zones diffusées du deuxième type de conductivité s'étendant autour de chaque évidement, les zones correspondant à deux évidements voisins se rejoignant, caractérisé en ce qu'une première série d'évidements (20-22) s'étend à partir de la face supérieure et une deuxième série d'évidements (30-33) s'étend à partir de la face inférieure, et en ce que les évidements ont une section rectangulaire dont la grande dimension est perpendiculaire à la ligne des évidements et ont une profondeur inférieure ou égale à la demi épaisseur du substrat.

5. Mur d'isolement selon la revendication 4, caractérisé en ce que les première et deuxième séries d'évidements, vues en projection perpendiculairement au plan du substrat, sont alternées.

6. Composant semiconducteur comprenant un mur d'isolement selon l'une des revendications 4 ou 5.
